# EUROPEAN PATENT APPLICATION

(11) **EP 3 115 875 A1**
(43) Date of publication of application: **11.01.2017**
(21) Application number: 16174148.3
(22) Date of filing: 13.06.2016
(51) Int. Cl.: G06F 3/044

(54) **CAPACITIVE SENSOR USING DUMMY WIRES FOR REDUCING MOIRE EFFECTS**

(30) Priority: 10.07.2015 JP 2015139005
(71) Applicant: Hosiden Corporation, Yao-shi, Osaka 581-0071 (JP)
(72) Inventor: Shinoda, Koji, OSAKA, Osaka 5810071 (JP)
(74) Representative: Lemcke, Brommer & Partner Patentanwälte Partnerschaft mbB

(57) **Abstract**

A capacitive sensor (1) includes an insulator substrate (10), a detecting electrode (20) formed on one face (10A) of the insulator substrate (10) by arranging a first electric wire (21) to provide a plurality of first annular portions (22), and a driving electrode (30) formed on the other face (10B) of the insulator substrate (10) by arranging a second electric wire (31) to provide a plurality of second annular portions (32). In a region where the detecting electrode (20) and the driving electrode (30) of the insulator substrate (10) are overlapped with each other as seen in a plan view, the second electric wire (31) is arranged such that a plurality of corner portions (70) of the second annular portion (32) are contained within the first annular portion (22).

## Description

### TECHNICAL FIELD

This disclosure relates to a capacitive sensor having a pair of electrodes formed in different layers via an insulator therebetween.

### RELATED ART

Conventionally, there has been employed a capacitive sensor having a driving electrode and a detecting electrode formed in different layers via an insulator therebetween. With this type of capacitive sensor, the smaller the coupling capacitance between the driving electrode and the detecting electrode, the greater an adjustment range can be obtained respecting high sensitivity on the IC side which utilizes detection result of the capacitive sensor. Therefore, smaller coupling capacitance is desirable.

As one method of decreasing the coupling capacitance, regarding respective conductive wires of the driving electrode and respective conductive wires of the detecting electrode, mesh patterns having a same shape and a same size are formed and then these mesh patterns are offset relative to each other by a half pitch as seen in a plan view, thus constituting a sensor. With this arrangement, however, the coupling capacitance between the driving electrode and the detecting electrode is significantly influenced by the pitch of the mesh pattern. Further, as a method of decreasing the coupling capacitance, it is also conceivable to vary the pitch of mesh pattern. However, when such capacitive sensor is employed in a liquid crystal panel, change of mesh pattern pitch makes difficult designing based on counter-moire measure designing rule which is derived from a shape of an LCD color filter, so that a difficulty may arise in ensuring favorable outer appearance quality. Then, it is conceivable to change the density of mesh from dense (high density) to sparse (low density), like a technique disclosed in Japanese Unexamined Patent Application Publication No. 2014-35612.

A touch panel disclosed in Japanese Unexamined Patent Application Publication No. 2014-35612 includes a transparent substrate, a first electrode having first conductive wires provided in the form of mesh on one face of the transparent substrate and a second electrode having second conductive wires provided in the form of mesh on the other face of the transparent substrate. A pitch of the first conductive wires is set as an integral multiple of a pitch of the second conductive wires.

### SUMMARY

According to Japanese Unexamined Patent Application Publication No. 2014-35612, the first electrode is configured to be overlapped with the second electrode as the touch panel is seen in a plan view. However, even when the first electrode is overlapped with the second electrode, positional error may occur due to a problem in alignment precision. In such case, the electric wires will appear "thicker" than the other portions, so visibility (in displaying) of a display screen disposed via this touch panel will deteriorate.

Then, as another method, it is conceivable to cope with the above by increasing an inter-layer distance between the driving electrode and the detecting electrode. However, this cannot be said to be advantageous for the sake of desirable thinness of arrangement.

Embodiments of the present invention are a capacitive sensor having high sensitivity and distinguished visibility.

According to one preferred embodiment of a capacitive sensor of this disclosure, a capacitive sensor comprises:
an insulator substrate;
a detecting electrode formed on one face of the insulator substrate by arranging a first electric wire along two directions to provide a plurality of first annular portions having a quadrangle shape; and
a driving electrode formed on the other face of the insulator substrate by arranging a second electric wire along two directions to provide a plurality of second annular portions having a quadrangle shape which is smaller than the quadrangle shape of the first annular portions;
wherein in a region where the detecting electrode and the driving electrode of the insulator substrate are overlapped with each other as seen in the plan view, the second electric wire is arranged such that a plurality of corner portions of the second annular portion are contained within the first annular portion.

With this arrangement, in the plan view of the detecting electrode and the driving electrode, apparent pitches constituted of the first electric wire forming the detecting electrode and the second electric wire forming the detecting electrode can be changed relative to each other. For this reason, even when the capacitive sensor is applied to a liquid crystal panel, a capacitive sensor having high sensitivity and distinguished visibility can be realized without deviating from the counter-moire measure designing rule.

Further, for instance, in case two corner portions of the second annular portion constituting the driving electrode are contained within the first annular portion included in the detecting electrode, this arrangement can be realized by forming the first annular portion as a rectangle characterized as: a length of its long side = a length of its short side x 2. In this case, by disposing a dummy wiring at the center of the first annular portion, the apparent mesh pattern constituted of the first electric wire, the second electric wire and the dummy wiring can have an equal spacing relative to each other, as seen in the plan view, so that the visibility can be improved. Needless to say, in the case of containing four or more corner portions of the second annular portion within the first annular portion, adaptation thereto is possible by changing the lengths of the long side and the short side of the first annular portion. In this way, by setting an aperture ratio (size of the first annular portion) of the mesh pattern of the detecting electrode greater than an aperture ratio (size of the second annular portion) of the mesh pattern of the driving electrode, the extension of an electric field from the driving electrode is increased, so that improvement of the detection sensitivity is made possible.

According to one preferred embodiment of the capacitive sensor of this disclosure, the capacitive sensor further comprises:
a dummy wiring having a third electric wire arranged on one or the other face of the insulator substrate;
wherein the third electric wire is arranged to partition the first annular portion of the insulator substrate into a same shape as the second annular portion as seen in the plan view.

With this arrangement, by providing the dummy wiring partially, there is no need to change the apparent pitches of the detecting electrode and the driving electrode. Consequently, the coupling capacitance can be reduced without deterioration of visibility.

Further, according to one preferred embodiment of the capacitive sensor of this disclosure, the third electric wire and either the first electric wire or the second electric wire arranged on a same face of the insulator substrate as the third electric wire are configured to have a portion where at least either one of the former and the latter is cut, so as not to intersect each other in the same face.

With this arrangement, intersection between the first electric wire constituting the detecting electrode, the second electric wire constituting the driving electrode and the third electric wire constituting the dummy wiring can be avoided, so the electrodes suffering no detection sensitivity deterioration can be formed.

Further, according to one preferred embodiment of the capacitive sensor of this disclosure, in a region of one face of the insulator substrate where the detecting electrode is not provided, a dummy wiring is formed by arranging a third electric wire along two directions so as to have a plurality of third annular portions having a same shape as the first annular portions; and

in a region where the dummy wiring of the insulator substrate and the driving electrode are overlapped with each other as seen in the plan view, the third electric wire is arranged such that a plurality of corner portions of the second annular portion are contained within the third annular portion.

With this arrangement, the apparent pitches of the detecting electrode and the driving electrode, and also the apparent pitches of the dummy wiring and the driving electrode can be made similar to each other. Therefore, even when the capacitive sensor is applied to a liquid crystal panel, a capacitive sensor having high sensitivity and distinguished visibility can be realized.

Further, according to one preferred embodiment of the capacitive sensor of this disclosure, the second electric wire and the third electric wire are arranged along two directions along which the first electric wire extends.

With this arrangement, the aperture ratios of the meshes of the insulator substrate constituted of the detecting electrode, the driving electrode and the dummy wiring as seen in the plan view can be made constant, so deterioration of visibility can be prevented.

### BRIEF DESCRIPTION OF THE DRAWINGS

Fig. 1 is an exploded perspective view of a capacitive sensor,
Fig. 2 is a view illustrating an example of electrode pattern formation of the capacitive sensor,
Fig. 3 is a view illustrating an example of electrode pattern formation of a capacitive sensor relating to a further embodiment,
Fig. 4 is a view illustrating an example of electrode pattern formation of a capacitive sensor relating to a further embodiment, and
Fig. 5 is an exploded perspective view of a capacitive sensor relating to a further embodiment.

### DESCRIPTION OF EMBODIMENTS

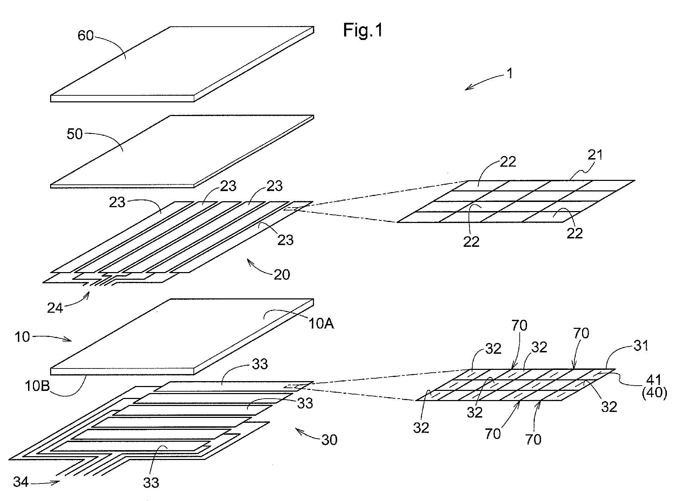

A capacitive sensor of this disclosure is used for detecting a user's operation on a touch panel. Next, a capacitive sensor 1 of this embodiment will be explained. Fig. 1 shows an exploded perspective view of the capacitive sensor 1. As shown in Fig.1, the capacitive sensor 1 includes an insulator substrate 10, a detecting electrode 20, a driving electrode 30, a dummy wiring 40, an adhesive sheet (OCA: Optical Clear Adhesive) 50, and a cover panel 60.

The insulator substrate 10 comprises a substrate in the form of a thin sheet made of an insulating material and is used as a substrate on which the detecting electrode 20, the driving electrode 30, and the dummy wiring 40 are formed. A liquid crystal monitor or the like can be provided under the capacitive sensor 1, and for allowing a user to view an image displayed thereon, a transparent substrate may be used as the insulator substrate 10 advantageously.

The detecting electrode 20 is formed by arranging a first electric wire 21 along two directions so as to obtain a plurality of quadrangle-shaped first annular portions 22 in one face 10A of the insulator substrate 10. The first electric wire 21 comprises a conductor forming the detecting electrode 20 and patterned on the one face 10A of the insulator substrate 10. The first electric wire 21 can be provided with using e.g. Cu, Ag, etc. However, Cr, Mo/Al/Mo, etc. can also be used. Also, the wire width of the first electric wire 21 is 10 µm or less, its pitch (a distance between two adjacent parallel portions of the first electric wire 21) should range from 500 to 2000 µm approximately. The first annular portion 22 refers to a minimal section partitioned by the first electric wire 21.

In the above, the language "along two directions" means predetermined two directions set in the insulator substrate 10. The first electric wire 21 is arranged along these two directions. As shown in Fig. 1, the detecting electrode 20 is constituted of a plurality of strip electrodes 23, and extension wires 24 are provided to extend from the respective strip electrodes 23. Further, Fig. 1 includes enlarged showing of a part of the strip electrode 23. As shown in this enlarged view, the first electric wire 21 is patterned so as to form a plurality of the quadrangle-shaped first annular portions 22. Two adjacent first annular portions 22 share sides adjacent each other.

The driving electrode 30 is formed by arranging a second electric wire 31 along two directions so as to obtain a plurality of quadrangle-shaped second annular portions 32 in the other face 10B of the insulator substrate 10. The second electric wire 31 comprises a conductor forming the driving electrode 30 and are patterned on the back face (face 10B) opposite to the face 10A of the insulator substrate 10 on which the detecting electrode 20 is formed. Similarly to the first electric wire 21, the second electric wire 31 can be provided with using e.g. Cu, Ag, etc. However, Cr, Mo/Al/Mo, etc. can also be used. Also, the wire width of the second electric wire 31 is 10 µm or less, its pitch (a distance between two adjacent parallel portions of the second electric wire 31) should range from 500 to 2000 µm approximately. The second annular portion 32 refers to a minimal section partitioned by the second electric wire 31.

In this embodiment, the second electric wire 31 is arranged to extend along the two directions along which the first electric wire 21 extends. Namely, the second electric wire 31 is arranged such that the respective extending directions of the second electric wire 31 are in agreement with the respective extending directions of the first electric wire 21. In this embodiment, as shown in Fig. 1, the driving electrode 30 is constituted of a plurality of strip electrodes 33, and extension wires 34 are provided to extend from the respective strip electrodes 33. Further, Fig. 1 includes enlarged showing of a part of the strip electrode 33. As shown in this enlarged view, the second electric wire 31 is patterned so as to form a plurality of the quadrangle-shaped second annular portions 32. Two adjacent second annular portions 32 share sides which are adjacent each other.

Further, the second annular portion 32 has a smaller size than the first annular portion 22. Here, though will be explained in greater details later herein, the above language "...has a smaller size" means that each second annular portion 32 has a smaller area than each first annular portion 22.

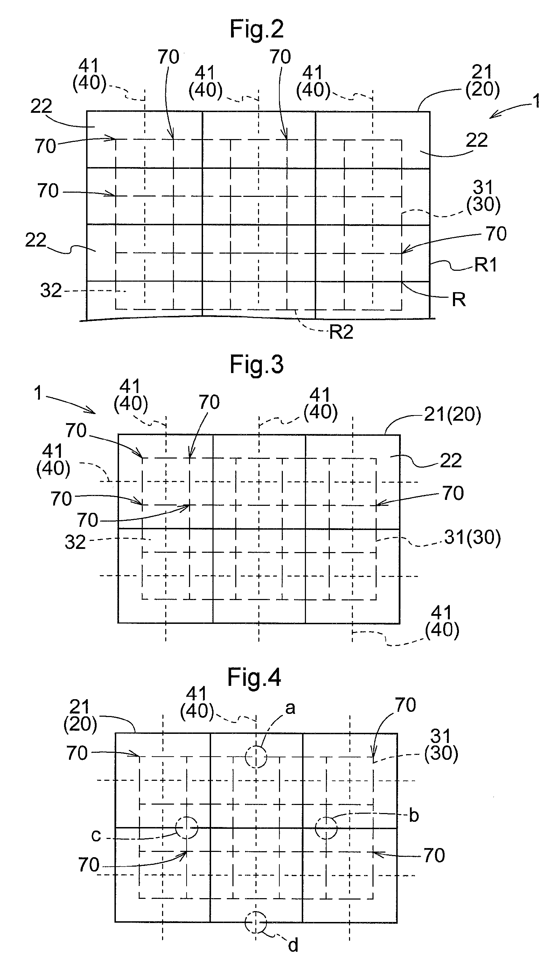

Here, Fig. 2 shows a portion of the detecting electrode 20 and the driving electrode 30 formed on the insulator substrate 10 as seen in the plan view. It is understood, however, that showing of the insulator substrate 10 is omitted therein for readiness of understanding. In this embodiment, as shown in Fig. 2, the second electric wire 31 denoted by broken lines is arranged such that in a region where the detecting electrode 20 and the driving electrode 30 of the insulator substrate 10 are overlapped with each other as seen in the plan view of the insulator substrate 10, a plurality of corner portions 70 of the second annular portion 32 are contained within the first annular portion 22 delimited by the first electric wire 21 denoted with solid lines. As described above, the first annular portions 22 and the second annular portions 32 both have a quadrangle shape as seen in the plan view. Therefore, the above language "corner portions 70 of the second annular portion 32" refers to the four corner portions constituting this second annular portion 32. In this embodiment, each first annular portion 22 contains therein two corner portions 70 of the second annular portion 32.

The dummy wiring 40 denoted by dotted lines in Fig. 2 includes a third electric wire 41 arranged on the one face 10A or the other face 10B of the insulator substrate 10. The third electric wire 41 is arranged in such a manner to partition the first annular portions 22 of the insulator substrate 10 into a same shape as the second annular portions 32 as seen in the plan view.

In this embodiment, the dummy wiring 40 is provided on the other face 10B of the insulator substrate 10. Similarly to the first electric wire 21, the third electric wire 41 can be provided with using e.g. Cu, Ag, etc. However, Cr, Mo/Al/Mo, etc. can also be used. Also, the wire width of the third electric wire 41 is 10 µm or less, its pitch (a distance between two adjacent parallel portions of the third electric wire 41) should range from 500 to 2000 µm approximately.

The above language "arranged in such a manner to partition the first annular portions 22 of the insulator substrate 10 into a same shape as the second annular portions 32 as seen in the plan view" means that when the insulator substrate 10 is seen from above perpendicularly, the first annular portion 22 delimited by the first electric wire 21 is partitioned by the third electric wire 41 into a section having the same size as the second annular portion 32. With this arrangement, at least in a region R where a region R1 where the first annular portion 22 is formed is overlapped with a region R2 where the second annular portion 32 is formed, the area delimited by the first electric wire 21, the second electric wire 31 and the third electric wire 41 can be divided into smaller and same size. For this reason, in this embodiment, as shown in Fig. 2, the third electric wire 41 is arranged along the one direction of the smaller pitch of the two extending directions of the first electric wires 21. That is, the third electric wire 41 is arranged such that the extending direction of the third electric wire 41 is in agreement with the extending direction of the first electric wire 21.

The third electric wire 41 and either the first electric wire 21 or the second electric wire 31 arranged on a same face of the insulator substrate 10 as the third electric wire 41 are configured to have a portion where at least either one of them is cut, so as not to intersect each other in the same face. In this embodiment, the third electric wire 41 is disposed on the face 10B of the insulator substrate 10 on which the second electric wire 31 is disposed. Therefore, the above language "the first electric wire 21 or the second electric wire 31 arranged on a same face of the insulator substrate 10 as the third electric wire 41" corresponds to the second electric wire 31.

Therefore, of the third electric wire 41 and the second electric wire 31, at least one thereof has a cut portion for avoiding intersection therebetween. In this embodiment, as shown in Fig. 2, the third electric wire 41 is cut at the intersection between the second electric wire 31 and the third electric wire 41. Incidentally, in this embodiment, since the first electric wire 21 of the detecting electrode 20, and the third electric wire 41 of the dummy wiring 40 and the second electric wire 31 of the driving electrode 30 are formed on the different faces of the insulator substrate 10, so the first electric wire 21 has no such cut portions.

The adhesive sheet 50 is a film-like adhesive sheet (optical glue) for use in bonding. This adhesive sheet 50 is used when the sensor panel constituted of the insulator substrate 10, the detecting electrode 20, the driving electrode 30 and the dummy wiring 40 is to be bonded/affixed with the cover panel 60 acting as a decorative plate or a decorative film.

With the above-described configuration of the capacitive sensor 1, the respective pitches of the first electric wire 21 forming the detecting electrode 20 and the second electric wire 31 forming the driving electrode 30 can be changed relative to each other. Further, by providing the dummy wiring 40 at a limited portion thereof, the coupling capacitance can be decreased without changing apparent pitches of the detecting electrode 20 and the driving electrode 30. For this reason, even when the capacitive sensor 1 is applied to a liquid crystal panel, a capacitive sensor 1 having high sensitivity and distinguished visibility can be realized without deviating from the counter-moire measure designing rule.

### [Other Embodiments]

In the foregoing embodiment, in Fig. 2, the first annular portion 22 of the detecting electrode 20 is shown as a rectangular shape (in particular, characterized as: the length of long side thereof = the length of short side thereof x 2). Alternatively, as shown in Fig. 3, the first annular portion 22 of the detecting electrode 20 can have a square shape. In such case, it is also possible to arrange such that the first annular portion 22 includes/contains the four corner portions 70 of the second annular portion 32 therein. Further, in the case of the example shown in Fig. 3, the third electric wire 41 of the dummy wiring 40 is provided on the face 10B same as the face 10B of the insulator substrate 10 on which the second electric wire 31 of the driving electrode 30 is provided and along the two extending directions of the first electric wire 21. In this case too, like the foregoing embodiment, advantageously, the third electric wire 41 should be cut at predetermined portions thereof so as to avoid intersection between the third electric wire 41 and the second electric wire 31.

In the foregoing embodiment, it was explained that the capacitive sensor 1 includes the dummy wiring 40 having the third electric wire 41 arranged on the one face 10A or the other face 10B of the insulator substrate 10. However, the capacitive sensor 1 can omit the dummy wiring 40.

In the foregoing embodiment, it was explained that of the third electric wire 41 and the second electric wire 31, at least either one thereof has cut at some portions, so as to avoid intersection therebetween on a same face. However, it is also possible to provide the third electric wire 41 on the same face as the first electric wire 21. In this case, advantageously, of the third electric wire 41 and the first electric wire 21, at least either one thereof has cuts at some portions, so as to avoid intersection therebetween on a same face.

Further, as shown in Fig. 4, similarly to Fig. 3, it is also possible to arrange such that the detecting electrode 20, the driving electrode 30 and the dummy wiring 40 are provided on the insulator substrate 10 and the second electric wire 31 of the driving electrode 30 is cut at an intersection (a) between the dummy wiring 40 and the driving electrode 30. Further, it is also possible to arrange such that at an intersection (b) between the detecting electrode 20 and the driving electrode 30, the second electric wire 31 of the driving electrode 30 is cut or such that at an intersection (c) between the detecting electrode 20 and the driving electrode 30, the first electric wire 21 of the detecting electrode 20 is cut, or such that at an intersection (d) between the detecting electrode 20 and the dummy wiring 40, the first electric wire 21 of the detecting electrode 20 is cut.

In the foregoing embodiment, explanation was made with the examples of the first annular portions 22 and the second annular portions 32 having square shape or rectangular shape. Alternatively, these may have a parallelogram shape or a rhombus shape.

In the foregoing embodiment, there was explained the example of the first electric wire 21, the second electric wire 31 and the third electric wire 41 being arranged in straight lines. Alternatively, these may be arranged in curved lines or in a desired shape.

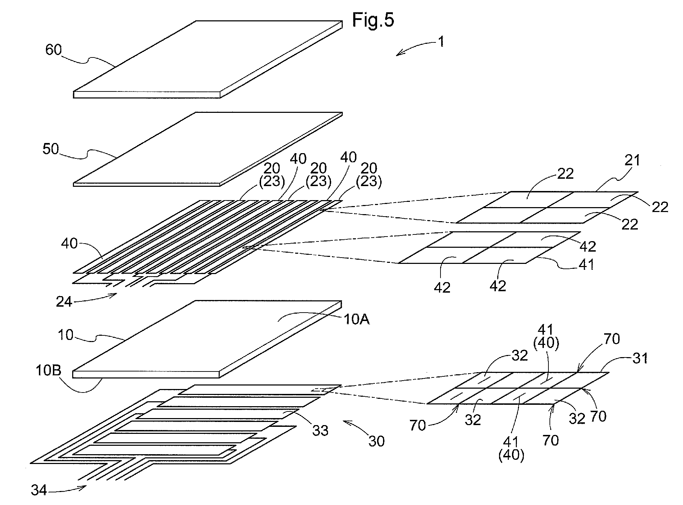

In the foregoing embodiment, it was explained that the third electric wire 41 of the dummy wiring 40 is arranged so as to partition the first annular portions 22 of the insulator substrate 10 into the same shape as the second annular portions 32 as seen in the plan view. Alternatively, as shown in Fig.5 for instance, in a region of the one face 10A of the insulator substrate 10 where the detecting electrode 20 is not provided, a dummy wiring 40 including a plurality of third annular portions 42 delimited by the third electric wire 41 arranged along the two directions and having the same shape as the first annular portions 22 may be arranged between two strip electrodes 23.

In this case, advantageously, the third electric wire 41 should be arranged such that in the region in the insulator substrate 10 where the dummy wiring 40 and the driving electrode 30 are overlapped with each other, a plurality of corner portions 70 of the second annular portion 32 are contained within the third annular portion 42. Namely, the dummy wiring 40 can be configured such that the relation between the third annular portion 42 and the second annular portion 32 is made similar to the relation between the first annular portion 22 and the second annular portion 32. In the case of such configuration, the apparent pitch of the detecting electrode 20 and the driving electrode 30 and the apparent pitch of the dummy wiring 40 and the driving electrode 30 can be made similar to each other. Therefore, even when the capacitive sensor 1 is applied to a liquid crystal panel, the capacitive sensor 1 having high sensitivity and distinguished visibility can be realized.

In the foregoing embodiment, it was explained that the second electric wire 31 and the third electric wire 41 are arranged along the two extending directions of the first electric wire 21. However, it is also possible to arrange such that the first electric wire 21, the second electric wire 31 and the third electric wire 41 are arranged along two directions different from each other.

This disclosure is applicable to a capacitive sensor having a pair of electrodes formed on different layers via an insulator.

## Claims

1. A capacitive sensor (1),
**characterized by**
an insulator substrate (10);
a detecting electrode (20) formed on one face (10A) of the insulator substrate (10) by arranging a first electric wire (21) along two directions to provide a plurality of first annular portions (22) having a quadrangle shape; and
a driving electrode (30) formed on the other face (10B) of the insulator substrate (10) by arranging a second electric wire (31) along two directions to provide a plurality of second annular portions (32) having a quadrangle shape which is smaller than the quadrangle shape of the first annular portions (22);
wherein in a region where the detecting electrode (20) and the driving electrode (30) of the insulator substrate (10) are overlapped with each other as seen in a plan view, the second electric wire (31) is arranged such that a plurality of corner portions (70) of the second annular portion (32) are contained within the first annular portion (22).

2. The capacitive sensor (1) according to claim 1:
**characterized in that**
the capacitive sensor (1) further comprises a dummy wiring (40) having a third electric wire (41) arranged on one (10A) or the other face (10B) of the insulator substrate (10); and
the third electric wire (41) is arranged to partition the first annular portion (22) of the insulator substrate (10) into a same shape as the second annular portion (32) as seen in the plan view.

3. The capacitive sensor (1) according to claim 2:
**characterized in that**
the third electric wire (41) and either the first electric wire (21) or the second electric wire (31) arranged on a same face of the insulator substrate (10) as the third electric wire (41) are configured to have a portion where at least either one of the former and the latter is cut, so as not to intersect each other in the same face.

4. The capacitive sensor (1) according to claim 1:
**characterized in that**
in a region of one face (10A) of the insulator substrate (10) where the detecting electrode (20) is not provided, a dummy wiring (40) is formed by arranging a third electric wire (41) along two directions so as to have a plurality of third annular portions (42) having a same shape as the first annular portions (22); and
in a region where the dummy wiring (40) of the insulator substrate (10) and the driving electrode (30) are overlapped with each other as seen in the plan view, the third electric wire (41) is arranged such that a plurality of corner portions (70) of the second annular portion (32) are contained within the third annular portion (42).

5. The capacitive sensor (1) according to any one of claims 2-4:
**characterized in that**
the second electric wire (31) and the third electric wire (41) are arranged along two directions along which the first electric wire (21) extends.
